(19) Europäisches Patentamt / European Patent Office / Office européen des brevets

(11) **EP 3 719 521 A1**

(12) **EUROPEAN PATENT APPLICATION**

(43) Date of publication:
**07.10.2020 Bulletin 2020/41**

(51) Int Cl.:
**G01R 33/345** (2006.01)   **G01R 33/36** (2006.01)
**G01R 33/46** (2006.01)   **G01R 33/56** (2006.01)
**G01R 33/30** (2006.01)   **G01R 33/34** (2006.01)

(21) Application number: **19167579.2**

(22) Date of filing: **05.04.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
• **Karlsruher Institut für Technologie**
  **76131 Karlsruhe (DE)**
• **Bürkert Werke GmbH & Co. KG**
  **74653 Ingelfingen (DE)**

(72) Inventors:
• **SILVA, Pedro**
  **76137 Karlsruhe (DE)**
• **KORVINK, Jan**
  **76228 Karlsruhe (DE)**
• **JOUDA, Mazin**
  **76344 Eggenstein-Leopoldshafen (DE)**

(74) Representative: **Müller-Boré & Partner**
    **Patentanwälte PartG mbB**
    **Friedenheimer Brücke 21**
    **80639 München (DE)**

(54) **AN NMR DETECTOR AND A CORRESPONDING NMR MEASUREMENT METHOD**

(57)    The invention relates to an NMR detector and a respective method for performing NMR measurements. The detector comprises a first sample accommodating space (20), a second sample accommodating space (22), at least one excitation coil configured to generate a unidirectional magnetic field across the first and the second sample accommodating spaces; and at least one reception coil (1) configured to:

generate a magnetic field having opposite directions across the first and the second sample accommodating spaces, respectively; and
simultaneously receive a first NMR signal from a first sample accommodated in the first sample accommodating space (20) and a second NMR signal from a second sample accommodated in the second sample accommodating space (22), thereby generating a compound NMR signal.

**FIG. 2**

EP 3 719 521 A1

**Description**

The invention relates to an NMR detector and a respective method for performing NMR measurements.

Nuclear magnetic resonance (NMR) is a powerful technique offering unmatched chemical specificity and structural molecular information. Despite its uncontested qualities in spectroscopy and imaging, it has stringent and hence restricting performance requirements regarding measurement sensitivity and magnetic field intensity/uniformity. These have prevented its integrated, downscaled use in chemical synthesis, flow-through analysis, low cost μTAS systems, point-of-care diagnosis, and other potentially portable NMR applications. As NMR has progressed into new application areas, and in order to maintain performance levels comparable to cryogenically achieved standard imaging and spectroscopic systems, varied approaches for systems implementation have been proposed. These have often featured a significant leap in at least one aspect of the technique, with all other concepts held constant, thus resulting either in a low level of integration or low versatility.

A problem encountered in NMR spectrometry is the complexity of the acquired spectra. From the acquired complex spectra, typically only some peaks are of relevance for a given application. Due to measurement limitations, the peaks oftentimes overlap, hiding important information. Furthermore, due to a limited range of measurement devices, in order to acquire peaks of high-abundancy, like a solvent, smaller abundancy species have their SNR reduced due to ADC quantization noise.

To improve the measurement sensitivity various approaches have been proposed. One of these approaches is based on differential NMR spectroscopy.

Existing differential NMR detectors implement a trivial solution of evaluating the signals from two samples (one being the sample to be measured and one being a reference sample) obtained by two substantially same and separate detector coils, multiplying one of the signals by -1, and numerically summing the two (see e.g. E. Ghafar-Zadeh, H. Pourmodheji and S. Magierowski, "Differential nuclear magnetic resonance receiver: Design, implementation and experimental results," 2016 IEEE International Symposium on Circuits and Systems (ISCAS), Montreal, QC, 2016, pp. 105-108). This approach requires two separate measurements by two separate NMR detector coils, and a very precise control of every aspect of the measurement arrangement and the measurement process, as any variation in power, amplification, phase or coil parameters will lead to non-cancellation of common mode signals. Further, coil and/or sample variations can even make differential results impossible. As there is a considerable physical distance separation between the two samples, this means different magnetic fields and thus frequency response, which can as a rule not be cancelled. Furthermore, both coils typically exhibit a non-zero difference in their sensitivity profiles. Accordingly, it is possible to tune the parameters to achieve a perfect cancellation for one frequency only. The other frequencies will be only dampened. Thus, the tuning parameters will need to be readjusted for different routines and pulse sequences, which is a complicated and error prone process.

Another option, which introduces some simplification is based on numerically subtracting two sequential measurements of the two different samples one wishes to subtract obtained with the same NMR detection coil. This is very time inefficient and would suffer from substantially the same drawbacks mentioned above with regard to the case of using two distinct detection coils. For example, when the sample is changed, small positioning effects change the measurement and therefore there is no perfect cancellation of the sequentially obtained signals.

The present invention addresses at least some of the above mentioned problems and aims to provide for an improved NMR detector and an NMR detection method.

According to an aspect, there is provided an NMR (Nuclear Magnetic Resonance) detector comprising:

> a first sample accommodating space;
> a second sample accommodating space,
> at least one excitation coil configured to generate a unidirectional magnetic field across the first and the second sample accommodating spaces; and
> at least one reception coil, configured to:

>> generate a magnetic field across the first and the second sample accommodating spaces, wherein the magnetic field vectors of the generated magnetic field have different, in particular substantially opposite directions in the first and the second sample accommodating spaces, respectively; and
>> simultaneously (i.e. within one measurement) receive a first NMR signal from a first sample accommodated in the first sample accommodating space and a second NMR signal from a second sample accommodated in the second sample accommodating space, thereby generating a compound NMR signal.

The term "excitation coil" ("transmission coil" or "transceiving coil") as used throughout the application refers to any element or structure capable of generating magnetic field across the first and the second sample accommodating spaces suitable for NMR (Nuclear Magnetic Resonance) measurements. For example, the excitation coil may be configured to generate a radiofrequency (RF) magnetic field. The generated magnetic field across the first and the second sample accommodating spaces is unidirectional, i.e. the magnetic field vectors across the first sample accommodating space are in substantially the same direction as the magnetic field vectors across the second sample accommodating space. Preferably, the generated excitation magnetic field is substantially homogeneous.

The term "reception coil" ("detection coil") as used throughout the present application refers to any element or structure capable of receiving (detecting) an NMR signal. In general, any element or structure capable of generating a magnetic field (e.g. a RF magnetic field) having substantially opposite directions (i.e. having magnetic field vectors with substantially opposite directions) in the first and the second sample accommodating spaces may be employed. Preferably the generated magnetic field across the first and the second sample accommodating spaces is homogeneous.

The excitation coil and the reception coil are preferably geometrically decoupled. In an example, the magnetic field generated by the excitation coil may be substantially orthogonal to the magnetic field generated by the reception coil.

With the NMR device according to the above aspect, the measurement signals of the two samples are obtained under substantially the same measurement conditions. Further, it is possible to realize both differential mode and common measurement modes and easily switch between them. In the differential mode the signal obtained by the reception coil is proportional to the difference of the NMR signals from the two samples accommodated in the sample accommodating spaces, respectively. In the common mode, the signal obtained by the reception coil is proportional to the sum of the NMR signals from the two samples accommodated in the sample accommodating spaces, respectively. It is also possible to realize a mixed mode measurement corresponding to a combination of a common mode and differential mode.

One particular advantage is the possibility to obtain a differential NMR measurement signal with a single measurement using a single reception (detection) coil, unlike in conventional differential NMR detectors. It has been surprisingly found out that this is possible by decoupling (e.g. geometrically decoupling) the excitation coil and the reception coil and leveraging the reciprocity principle.

Generally, a planar, circular NMR coil has an equal signal contribution of all spins around its azimuth, despite its magnetic field pointing in different directions. This is a consequence of the introduction of a phase on the voltage generated by each spin, cancelling out the effect of different magnetic field directions by reciprocity, which leads to all signals summing constructively.

In the NMR detector according to the above aspect, the excitation and detection can be performed by separate (for example geometrically decoupled) coils, so that the effect attributed to different magnetic field directions remains present. More specifically, the excitation coil (Tx coil) can impart a uniform spin phase across the sample volumes ($\vec{e}_{Tx} \rightarrow \vec{x}x$), whereas the reception coil (Rx coil) can break the symmetry, such that the spins in the two sample volumes are 180° out of phase. Accordingly, the signals from the spins of the two samples received by the reception coil will have a phase difference of Pi and the measured result signal will be proportional to the difference of the signal contributions from each sample. Thus, the measured result signal will be a differential signal.

The above conditions may be realized by the provision of an excitation coil generating a unidirectional magnetic field across the sample volumes and a reception (detection) coil generating a magnetic field having magnetic field vectors with substantially opposite directions in the two sample volumes, respectively.

To realize a differential mode measurement, the NMR detector may be configured such that the excitation of the samples in the respective sample accommodating spaces is carried out by the excitation coil and the reception of the NMR signals from the samples is carried out by the reception coil. The excitation magnetic field generated by the excitation coil aligns the spins in the two samples and the reception coil naturally subtracts the signals from the two measured samples.

To realize a common mode measurement, the NMR detector may be configured such that both the excitation of the samples in the respective sample accommodating spaces and the reception of the NMR signals is carried out by the reception coil. In this case, the signal detected by the reception coil will be proportional to the sum of the NMR signals from the two samples accommodated in the respective sample accommodation spaces.

To realize a mixed mode measurement, the NMR detector may be configured such that the excitation of the samples in the respective sample accommodating spaces is performed by both the excitation coil and the reception coil and the reception of the NMR signals from the samples is carried out by the reception coil. The contributions of the excitation coil and the reception coil to the excitation (i.e. the corresponding excitation amounts attributed to the reception coil and the excitation coil, respectively) may be the same or different. For example, when performing a differential measurement, the samples may be excited mainly by the excitation coil. However, the reception coil may too have a small contribution to the excitation, for example to fix or compensate for incorrection.

The switching between the common mode, the differential mode and/or a mixed mode (including the switching of the excitation coil and the reception coil and/or the control of the strength of the magnetic fields generated by each of these coils) may be performed by a suitable switching and/or control mechanism.

More specifically:

In the NMR detector of the above aspect, the two samples S1 and S2 accommodated in the first and the second sample accommodating spaces, respectively, may be excited with the magnetic fields $E_{X1}$/$E_{X2}$ across the sample accommodating spaces generated by the excitation coil, with the magnetic fields $S_{X1}$/$S_{X2}$ generated by the reception coil or with any combination of both. The principle of reciprocity (see e.g. D. Hoult and R. Richards, "The signal-to-noise ratio of the nuclear magnetic resonance experiment", Journal of Magnetic Resonance (1969), 1976, 24, 71-85) states that the resulting NMR signal from an induction in a coil receiving the signal (i.e. the reception coil) is proportional to the dot product of the field $B$ created by the reception coil and the spin magnetization $M$ (precessing magnetization). Thus, the resulting signal from the two samples S1 and S2 detected by the receiving coil can be approximated as:

$$M_{S1} \cdot B_1 + M_{S2} \cdot B_2 \qquad (1)$$

(i.e. the contributions of the two samples S1 and S2).

In the above equation, $M_{S1}$ is the precessing magnetization of the first sample S1, $M_{S2}$ is the precessing magnetization of the second sample S2, $B_1$ is the magnetic field of the reception coil in the first sample S1 and $B_2$ is the magnetic field of the reception coil in the second sample S2.

Given that each magnetization $M_{S1}$, $M_{S2}$ is proportional, after a pulse, to the excitation field ($T_X$) and $B$ represents the excitation field of the reception coil ($R_X$), the detected signal for two samples S1 and S2 with different frequency amplitudes ($c_{S1}$ and $c_{S2}$, respectively) can be rewritten as:

$$c_{S1} \cdot R_{X1} \cdot T_{X1} + c_{S2} \cdot R_{X2} \cdot T_{X2} \qquad (2)$$

For a readout with the same coil as the one used for excitation, the excitation ($T_X$) and reception ($R_X$) magnetic fields are generally the same, i.e. $S_X$, and the detected signal is thus:

$$(c_{S1} + c_{S2}) \cdot S_X \cdot S_X \qquad (3)$$

which is a common mode reception of the signals from the two samples.

If the excitation is carried out with the excitation coil ($T_X$) and the reception with the reception coil ($S_X$), and considering that $E_{X1} \cdot S_{X1} = -E_{X2} \cdot S_{X2}$, one obtains a detected signal of:

$$(c_{S1} - c_{S2}) \cdot S_X \cdot E_X \qquad (4)$$

which is a differential mode reception of the signals from the two samples.

Remarkable is that the differential signal is obtained "geometrically", i.e. because of the detector's configuration, rather than by a numerical subtraction of separate measurement signals. The differential signal is obtained within the same measurement and with the same detection coil by taking advantage of the magnetic fields generated by the excitation and the detection coil and the above described principle of breaking the symmetry.

The above principle of operation may be generalized to any pair of structures configured to fulfill the following condition that an integral in Space_1 of R_X1.M(T_X1) equals the integral in Space_2 of R_X2. M(T_X2) for any spaces 1 and 2.: In other words, the above principle of operation may be generalized to any pair of structures fulfilling the condition:

$$\iiint_{Space\ 1} R_{X1} \cdot M(T_{X1}) = -\iiint_{Space\ 2} R_{X2} \cdot M(T_{X2}) \qquad (5)$$

wherein:

$T_{X1}$ is the magnetic field generated by the excitation coil across the first sample accommodating space, i.e. across the first sample S1;
$T_{X2}$ is the magnetic field generated by the excitation coil across the second sample accommodating space, i.e. across the second sample S2;
$R_{X1}$ is magnetic field generated by the reception coil across the first sample accommodating space, i.e. across the first sample S1; and

$R_{X2}$ is magnetic field generated by the reception coil across the second sample accommodating space, i.e. across the second sample S2;

$M(T_{Xi})$, $i$ = 1, 2 is the magnetization as a function of the magnetic field generated by the excitation coil;

Space 1 is the first sample accommodating space; and

Space 2 is the second sample accommodating space

For a microscopic signal equation (5) may be simplified to:

$$R_{X1} \cdot T_{X1} = -R_{X2} \cdot T_{X2}, \qquad (5')$$

Further, the above principle can be directly extended to magnetic resonance imaging (MRI) if for example both samples are encompassed in the same excited slice and only one of the two samples is locally modified.

The NMR detector according to the above aspects and examples has a number of advantages. For example, the measurement signals of the two samples are obtained under substantially the same measurement conditions, thus resulting in two spectra that have an opposite phase and that are thus easy to tell apart. If the two peaks overlap, this creates a total cancellation of the signal, which is particularly useful when aiming for suppression of high-abundance peaks (e.g. solvents), without artefacts or the suppression of overlapping information, and when handling complex spectra. Further advantages include an easier and better control of the parameters of the measurement arrangement and process, faster measurements, as no two separate sequential measurements are needed, easier and better optimization of the measurement parameters not only for one frequency but for a range of frequencies.

Still further, it is possible to easily implement any combination of common and differential-mode excitation, meaning that the excitation angle, and thus the signal intensity, can be independently set for each sample. Accordingly, it is possible to precisely subtract peaks that are up to one million times more abundant than the substance of interest.

Beyond the simplification of the received information, a differential result also directly improves the SNR (Signal-to-Noise Ratio) by:

- removing common-mode background signals (e.g. interference/ coupling) and shared white-noise sources;
- reducing the dynamic range of the signal and thus the quantization noise introduced during digitization;
- narrowing linewidths through drift-corrected averaging and the reduction of radiation damping from large-signals.

Further advantages include low complexity, scalability, easiness of miniaturization. The NMR detector can be easily manufactured using, for example, conventional lithography technologies.

In an example, the NMR detector may exhibit a flat, planar construction or design, for example based on conventional Printed Circuit Board (PCB) technology. The height-to-width aspect ratio may be in the range of 1:100 to 1:3. The overall height or thickness of the NMR detector may be for example in the range of 10μm to 10 cm, the width may be for example in the range of 10μm to 10 cm. The length may be suitably selected, for example to be greater than the width. A planar design based on PCBs not only allows for a low-cost implementation of the complete NMR system, including for example RF coils, shims and gradients, but also for better interface with microfluidic chips or channels, which are generally flat.

Further, an NMR detector having a substantially planar design is particularly suitable for use with gap magnets.

In an example, the reception coil may be a stripline coil (stripline). A stripline comprises a central strip of conductive material (e.g. metal) arranged between two substantially parallel conductive shielding plates. This realizes a substantially non-radiative closed configuration, that has excellent shielding properties. Instead of stripline it is also possible to use a microstrip coil configuration in which one of the shielding plates is omitted.

In order to increase measurement sensitivity, the width of the strip may be non-uniform. For example, the strip may have an hourglass shape with a narrow middle portion and two side portions, each having a gradually or stepwise increasing width.

The strip may be electrically connected in parallel to the shielding plates, for example by a plurality of conductive pins and optionally through other components, such as intermediate conductive layers, capacitors and/or varactors. The use of a plurality of pins (for example arranged in a one- or two-dimensional array) enables low resistivity connection. Some of the pins may be used for connection with other electronic components, such as interconnection of shim and/or gradient coils. Further, the pins enable direct assembly after a commercial PCB manufacturing process.

A stripline coil generates a magnetic field having magnetic field lines encircling the central strip, so that the B field points in opposite directions above and below the central strip. Further, because of the boundary conditions, the magnetic field lines run substantially parallel to the strip's surface and the homogeneity of the magnetic field is good. Accordingly, there exists a relatively large area/volume above and below the strip where the first and the second sample accommodating spaces can be arranged. Preferably, if the strip has an hourglass shape, the first and the second sample accommodating spaces are arranged above and below the narrow central middle portion of an hourglass-shaped strip.

Employing a stripline as a reception coil has many advantages, such as higher sensitivity, higher self-resonance, scalability and easy integration with electronic components, microfluidic chips and planar sample holders. Further, it is possible to form the NMR detector in a planar design with planar sample accommodating spaces and thus planar sample holders (such as microchannels) using preferably the complete cross section of the available space of the stripline design. As mentioned above, the height-to-width aspect ratio of the cross section of the sample accommodating spaces may be relatively large, for example 1:3. Still further advantage of the stripline design is the ease of manufacture by using conventional lithography methods.

In addition, a stripline creates a magnetic field with magnetic field lines or vectors generally in one plane. Accordingly, the excitation coil (e.g. an excitation coil having a solenoid or a solenoid-like flat design) can be placed at a 90-degree rotation, to be fully decoupled from the stripline. In this arrangement, an excitation by the excitation coil would generally not induce any voltage on the stripline.

In an example, the NMR detector may comprise at least one electronic element, such as a capacitor and/or a varactor, arranged partially or fully in the space between the shielding plates of the stripline. The at least one electronic element (such as at least one capacitor and/or at least one varactor) be employed to adjust or tune the resonant frequency of the reception coil (i.e. the stripline), for example depending on the target sample. In an example, the at least one electronic element (such as at least one capacitor and/or varactor) may be electrically connected to the strip and to the shielding plates. The connection may be via an intermediate conductive layer and a plurality of conductive pins.

As mentioned above, a stripline is a very efficient NMR reception coil. However, in conventional designs it has always been used in high field (measurement frequency >100 MHz) situations. The use of capacitors and varactors inside the shield allows for their use in parallel, which allows for a resonant frequency of the LC resonator below 100 MHz without introducing extra resistance. This leads to an equivalent quality factor of the capacitor array that is much larger than that of the stripline. Further, since the resonator amplifies the current before it exits the cover of the stripline, which means that a far better shielding against outside electromagnetic noise can be achieved.

The above aspect of employing capacitors and/or varactors and/or other elements at least partially inside the shield of a stripline, i.e. at least partially between the shielding plates of a stripline may be applied to any NMR detector comprising a stripline as a reception coil, not only to the NMR detector described above.

Accordingly, another aspect of the invention relates to an NMR detector comprising:

> at least one sample accommodating space,
> at least one stripline as an excitation and/or reception coil, said stripline comprising a strip of conductive material arranged between two substantially parallel shielding plates of conductive material (e.g. metal such as Cu); and
> at least one electronic component, such as a capacitor and/or varactor, arranged partially or fully in the space between the shielding plates of the stripline.

Any stripline design may be employed, for example the stripline design described above.

The NMR detector may further comprise at least one sample holder for holding at least one of the samples to be measured. The sample holder may be a detachable sample holder or a sample holder permanently integrated within the NMR detector. In an example, the sample holder may comprise at least one reservoir for holding a fluid sample (e.g. a liquid sample), a fluid inlet and a fluid outlet. The reservoir may have a substantially flat or planar shape. For example, the sample holder may comprise at least one planar channel having a height-to-width aspect ratio in the range of 0.1 to 100, preferably in the range of 1 to 10. The channel may have a flow, in a central region thereof, that only changes across the thickness. If a stripline having an hourglass-shaped strip is employed as a reception coil, the reservoir (e.g. the microfluid channel) may exhibit a narrow middle portion having a shape generally corresponding to the shape of the narrow middle portion of the hourglass-shaped strip. Any other arrangements or forms suitable to contain fluid or non-fluid samples are possible.

The NMR detector may comprise further components such as electronic components, connectors, shim/gradient coils, etc.

The NMR detector may also comprise a plurality of pairs of sample accommodating spaces and the corresponding pairs of excitation and detection units.

According to yet another aspect, there is provided an NMR system comprising a magnet and the NMR detector according to any one of the above aspects and examples. The magnet may be configured to generate a constant (e.g. static) magnetic field, in particular across the first and the second sample accommodating spaces. The applied magnetic field ($B_0$) causes an alignment (polarization) of the magnetic nuclear spins of the measured samples typically required for an NMR measurement.

Any suitable type of magnet may be employed. For example, it is possible to employ permanent magnets, such as cylindrical Halbach arrays. Such magnets can realize high field strength, low fringe field and good homogeneity.

In an example, the magnet may be a gap magnet having a first and a second substantially planar magnetic layers and the NMR detector may be arranged between the first and the second magnetic layers. Gap magnets are particularly suitable for miniaturized integration, require only two planar magnetic layers, so that their design requires virtually no specialized approach. Further, their geometry features multidirectional access at an acceptable field strength compromise. Gap magnets are also perfectly suited to lab-on-a-chip and lab-on-a-disk systems.

As mentioned above, the NMR detector and thus the NMR system may be miniaturized.

The NMR system may further comprise additional components and/or units, such as additional electronic components. For example, the NMR system may further comprise one or more of:

a signal processing unit comprising a signal digitizing unit for digitizing the obtained compound signal and/or a signal amplification unit for amplifying the obtained compound unit;

a control unit for controlling the measurement process, said control unit including for example a switching unit for switching the excitation coil and the reception coil; and

power supply unit for supplying electrical power to the excitation and reception coils as well as to other units;

interfaces to other units such as computing units, etc.

The NMR system may be for example an NMR spectroscopy system or an MRI imaging system.

Still further aspect of the invention relates to a method for performing an NMR measurement of a first sample and a second sample, comprising

providing at least one an excitation coil configured to generate a unidirectional magnetic field across the first sample and the second sample;

providing at least one a reception coil configured to generate a magnetic field across the first sample and the second sample, respectively, wherein the magnetic field vectors of the generated magnetic field have different, in particular opposite directions in the first and the second samples, respectively; and

exciting the first sample and the second sample by the magnetic field generated by the at least one excitation coil and/or the magnetic field generated by the at least one reception coil; and

detecting, by the at least one reception coil a compound NMR signal by simultaneously receiving a first NMR signal from the first sample and a second NMR signal from the second sample, said first and second samples being subjected to said magnetic field generated by the reception coil, i.e. being subjected to the magnetic field of the reception coil having opposite directions in/across the first and the second samples, respectively.

The method may be performed by employing an NMR detector according to any of the above described aspects and examples. Accordingly, all explanations, features and advantages described in connection with the NMR detector apply also regarding the NMR measurement method according to the above aspect.

In particular, the generated magnetic fields may fulfill the condition:

$$\iiint_{Space\,1} R_{X1} \cdot M(T_{X1}) = - \iiint_{Space\,2} R_{X2} \cdot M(T_{X2}) \,, \qquad \text{(see equation 5)}$$

wherein:

$T_{X1}$ is the magnetic field generated by the excitation coil across the first sample accommodating space;

$T_{X2}$ is the magnetic field generated by the excitation coil across the second sample accommodating space;

$R_{X1}$ is the magnetic field generated by the reception coil across the first sample accommodating space; and

$R_{X2}$ is the magnetic field generated by the reception coil across the second sample accommodating space:

$M(T_{Xi})$, $i$ = 1, 2 is the magnetization as a function of the magnetic field generated by the excitation coil;

Space 1 is the first sample accommodating space; and

Space 2 is the second sample accommodating space.

As mentioned above, for a microscopic signal the above condition may be simplified to:

$$R_{X1} \cdot T_{X1} = -R_{X2} \cdot T_{X2}, \qquad \text{(see equation 5').}$$

As explained above, the excitation of the samples may be performed by the excitation coil, by the reception coil or by any combination of the two coils.

If the excitation is performed by the excitation coil and the signal detection is performed by the reception coil, a differential mode measurement may be realized, wherein the compound signal is a differential signal proportional to the difference between the first and the second NMR signals obtained from the first sample and the second sample, respectively.

Further, it is possible to perform a common mode measurement by employing the reception coil for both excitation and detection, thus obtaining a signal proportional to the sum of the first NMR signal and the second NMR signal.

Still further, it is possible to perform a mixed mode measurement by employing both the reception coil and the receiving coil for excitation and employing the reception coil for detection.

In an example, the method may employ a stripline reception coil comprising a strip of conductive material arranged between two substantially parallel shielding plates. The structure and the advantages of employing a stripline have been discussed above in connection with the NMR detector.

The method may further comprise adjusting or tuning the resonant frequency of the reception coil. In an example, this may be achieved by at least one electronic component, such as a capacitor and/or a varactor, arranged partially or fully in the space between the shielding plates of the stripline, as explained above in connection with the NMR detector. The adjusting or tuning of the resonant frequency of the reception coil by elements (such as at least one capacitor and/or at least one varactor) arranged at least partially in the space between the shielding plates of a stripline may be applied to any NMR detector including a stripline, i.e. also to stripline NMR detectors which do not comprise an excitation coil (secondary excitation coil) in addition to the stripline, which acts as both excitation and reception coil.

The NMR detector and the NMR measurement method according to various aspects and examples described in the application may be employed to obtain NMR measurements results from many different types of samples. For example, they may be used to performed NMR spectroscopy and imaging. Further, they can be used to measure fluid samples, and in particular flowing samples. Exemplary application fields include detection of altered metabolites, chemical by-products, solvent suppression, running chemical alterations, molecular structures, sample composition, etc. Further, the NMR detector and the corresponding measurement method may be employed for obtaining MRI images of samples (i.e. for MRI imaging).

In the following text, a detailed description of examples will be given with reference to the drawings. Various modifications to the examples may be made. In particular, one or more elements of one example may be combined and used in other examples to form new examples.

**Brief description of the drawings**

Figure 1 shows an exploded perspective view of an exemplary stripline NMR detector;
Figure 2 shows the magnetic field of the stripline;
Figure 3 is an exploded perspective view of the exemplary stripline NMR detector with a secondary coil;
Figure 4 shows a cross sectional view of the exemplary stripline NMR detector along a line AA';
Figure 5 shows a cross-sectional view of the exemplary NMR detector along a line BB';
Figure 6 shows the phase of MRI images of two samples S1 and S2 obtained by a common mode measurement method (left) and by a differential measurement method employing an exemplary stripline NRM detector (right);
Figure 7 shows an exemplary circuit for tuning and switching the reception (detection) coil;
Figure 8 shows an exemplary circuit for switching and matching the excitation coil (secondary coil) and for power amplification.

In the figures the same reference signs are used to denote the same or similar elements or components. Further, some of the figures are schematic drawings, wherein the elements may be not shown up to scale or some elements may be omitted for a better comprehension.

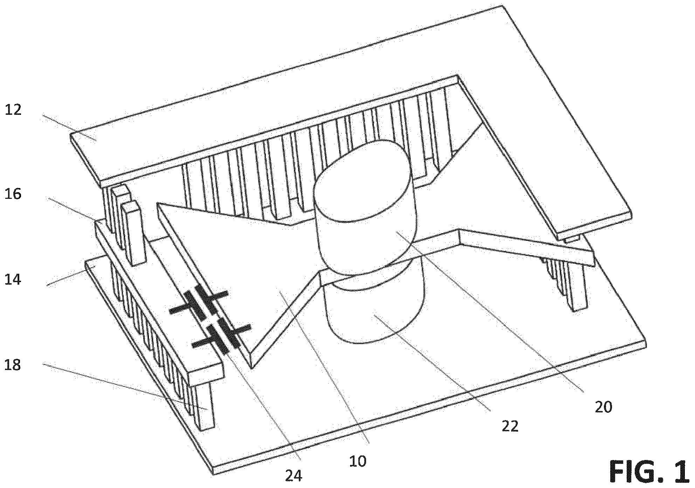

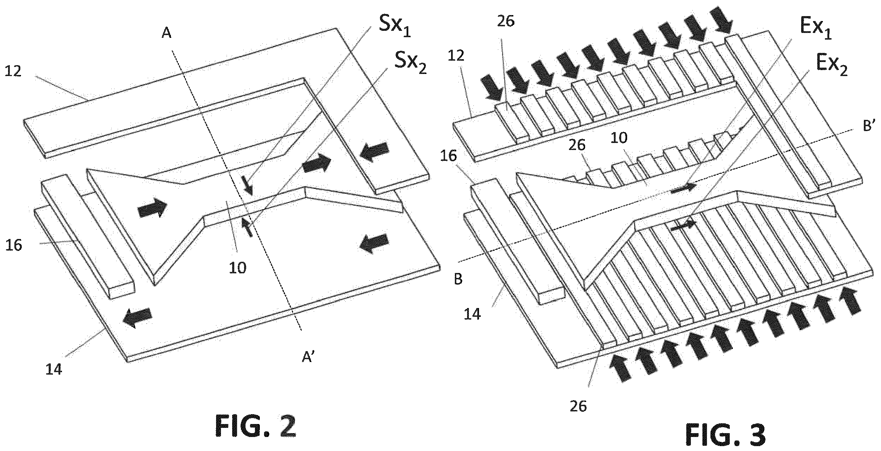

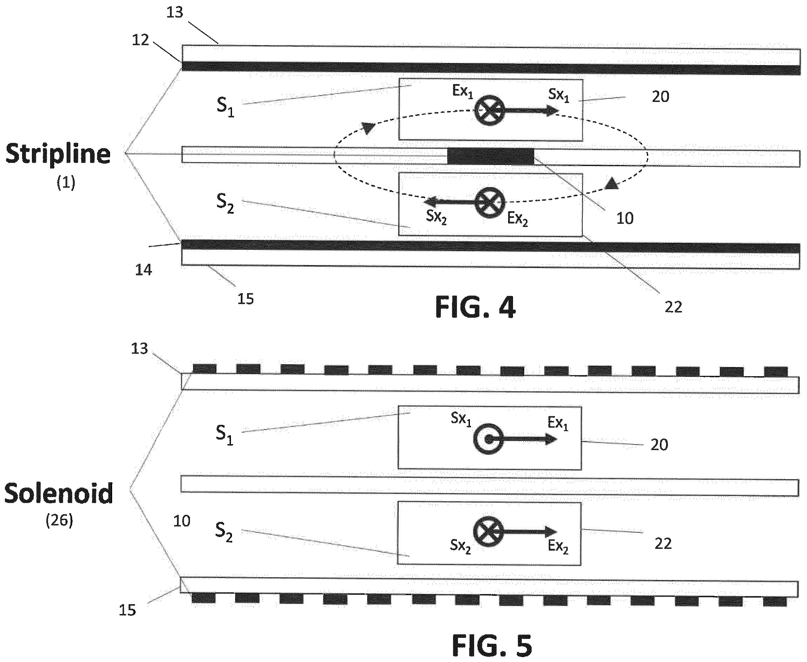

Figures 1 to 5 show different views of an exemplary stripline NMR detectors, without a secondary coil (see e.g. Figs. 1 and 2) or with a secondary coil (see e.g. Figs. 3 and 5).

The exemplary NMR detector comprises a stripline 1 as reception (detecting) coil, i.e. is a stripline detector. The stripline detector may be used as a standalone receive-only channel, in order to achieve an optimal detection. The stripline detector may be arranged between the two planar magnetic layers of a gap magnet (not shown in the figures).

The NMR detector comprises a stripline 1 constituted by a thin strip of conductive material 10 (e.g. a metal) arranged between two conductive shielding (ground) plates 12 and 14 (e.g. from Cu). In Figures 1 to 3 a part of the top shielding plate 12 is omitted to aid understanding.

The strip 10 has an hourglass shape with a non-uniform width, in order to increase the measurement sensitivity. The strip 10 exhibits a narrow portion in the middle (narrow neck portion) and two side portions, each having a gradually increasing width towards the respective end of the strip 10. Other strip forms are also possible. For example, the width of the strip 10 may increase stepwise rather than gradually towards the ends of the strip 10. Alternatively, the strip 10 may have a uniform width.

The shielding plates 12 and 14 are substantially planar and parallel to each other. Each of the shielding plates 12 and 14 may be provided on a substrate 13 or 15, respectively (see e.g. Fig. 4). The substrates 13 and 15 may for example be of FR4 . The strip 10 is embedded in a dielectric (such as for exampleFR4), that is sandwiched between the shielding plates 12 and 14. The strip 10 is electrically connected in parallel to the top and bottom shielding plates 12 and 14, respectively, via an intermediate conductive layer 16 and a plurality of conductive pins 18 (e.g. arranged in a row) on both sides of strip 10 connected to the intermediate layer 16 and the top shielding plate 12 or the bottom shielding plate 14, respectively. Some pins may be left unused or may be re-purposed to conduct other signals (shims, gradients, excitation, etc.).

In an example, the strip 10 may be connected to the intermediate conductive layer 14 via a capacitor 24 or a plurality of capacitors. The capacitor 24 may be arranged fully within the shield provided by the shielding plates 12 and 14. Thus, as explained above, it is possible to adjust or change the resonance frequency of the stripline coil.

The NMR detector comprises further two sample accommodating spaces 20 and 22, each sample accommodating space being configured to accommodate a respective sample (samples S1 and S2). One of the sample accommodating spaces may contain a reference sample and the other one a sample to be measured. The two sample accommodating spaces 20 and 22 are arranged substantially symmetrically below and above the strip 10, respectively, and in close proximity to the strip 10. The first sample accommodating space 20 is arranged in the space between the strip 10 and the top shielding plate 12 and the second sample accommodating space is arranged in the space between the central conductor and the bottom shielding plate 14. If the strip has an hourglass shape (as in Figs. 1 to 5), the sample accommodating spaces (sample volumes) 20 and 22 are arranged above and below the thin narrow portion (neck portion) in the middle of the strip 10, respectively.

In an example, each sample accommodating space may be have planar form with a rectangular cross-section. The dimensions of each sample accommodating space may be in the single micrometer range to a meter range. In an example, each sample accommodating space may exhibit size 10mm x 10mm x 3mm. The specific dimensions of each sample accommodating space may be tailored to the specific application of the NMR detector.

The NMR detector may further comprise a secondary coil 26 (as an example of an excitation coil), as shown in Figs. 3 and 5. The secondary coil 26 may be a solenoid having a plurality of windings. Other types of coils configured to produce a unidirectional and preferably substantially homogeneous magnetic field across the sample accommodating spaces may be employed instead of a solenoid. The windings of the secondary coil 26 may be provided on each of the substrates 13 and 15, respectively, on the side opposite to the side on which the shielding plates 12 and 14 are provided. The windings may be perpendicular to the axis of the stripline.

In the specific example shown in the figures, the Tx coil is a flat solenoid coil comprising an array of parallel straight tracks, perpendicular to the axis of the stripline, all connected electrically in parallel and placed on the outermost layers of a PCB assembly. This enables a planar implementation with very good homogeneity of the generated magnetic field.

Geometrically, a stripline 1 offers a planar design that is suitable for use in narrow gap magnets. As mentioned above, the stripline has a number of advantageous properties that make it particularly suitable for NMR measurements, such as high detection sensitivity and ambient noise shielding. For example, the stripline exhibits an increased sensitivity over that of a solenoid by a factor of $\sqrt{2}$. Further technical advantages are the ease of integration with PCB-like planar fabrication, a central and symmetric placement of the sensitive volume, and facile and modular fabrication/assembly.

The NMR signal amplitude is known to be directly proportional to the excitation magnetic field $B_1$, defined through the principle of reciprocity (see e.g. D. Hoult and R. Richards, Journal of Magnetic Resonance, (1969), 1976, 24, 71-85). For a coil with a unitary field of $B_i$ at the reference spectrometer phase, temperature $T$ and resistance $R_{\omega 0}$, and a sample with a precessing magnetization $M$, the signal-to-noise ratio SNR is:

$$SNR = \frac{\int \frac{\partial}{\partial t} \mathbf{M} \cdot \mathbf{B}_i dV_{sample}}{\sqrt{4\pi k_B T \Delta f R_{\omega 0}}} \propto \frac{B_i}{\sqrt{R_{\omega 0}}} \qquad (6)$$

Equation (6) may serve as an objective function for a geometrical optimization of the stripline NMR detector and the obtained signal from the two sample volumes 20 and 22, one above and one below the strip 10.

In an example, optimization of the stripline detector may be performed for a particular frequency, for example for a Larmor frequency of 44.8 MHz, corresponding to a commercial 1.05 T system using an electromagnetic wave propagation FEM simulator (e.g. COMSOL Multiphysics, COMSOL AB). Given the skin depth at the working frequency, and a well-defined target volume, only the width of the narrow strip may be left as a degree of freedom for the optimization.

An exemplary optimized stripline may have a narrow 7 mm wide path, for optimal sensitivity, and may be 10 mm in length, widening rapidly up to a width of 34 mm. This was found to achieve a near optimal total sensitivity while still maintaining an acceptable homogeneity of signal contribution from the target volume. Other dimensions are also possible.

A specific implementation of the stripline NMR detector may comprise a central PCB containing the strip 10 and preferably further electronic components (such as further indictive and/or capacitive elements, switching elements, etc.) and two additional PCBs having Cu layers that realize the shielding/return paths. The total stack thickness may be for example in the range of $10\mu m$ to 10 cm, the width may be for example in the range of $10\mu m$ to 10 cm. The stack thickness can be easily reduced to below 10 mm by using thinner dielectric layers.

**Figs. 2** and **4** show the magnetic field above and below the stripline, respectively, i.e. above and below the strip 10. As shown in these figures, the magnetic field $S_{X1}$, above the stripline (i.e. above the central conductor 10) and the magnetic field $S_{X2}$ below the stripline (i.e. below the central conductor 10) are in different (opposite) directions. Accordingly, the magnetic field $S_{X1}$ in the sample accommodating space (sample volume) 20 above the strip 10 and the magnetic field $S_{X2}$ in the sample accommodating space (sample volume) 22 below the strip 10 are in the different directions. Since the sample accommodating spaces 20 and 22 are arranged substantially symmetrical with respect to the strip 10, the magnitude of the magnetic fields are substantially equal, i.e. $S_{X1} = -S_{X2}$.

**Figs. 3** and **5** shows the magnetic field of the secondary coil 26 above and below the strip 10, respectively. As shown in these figures the magnetic field $E_{X1}$ above the strip 10 and the magnetic field $E_{X2}$ bellow the strip 10 are in the same direction, i.e. the magnetic field of the secondary coil is unidirectional. Further, in this example, the magnetic field of the secondary coil 26 is substantially orthogonal to the magnetic field of the stripline (i.e. $E_{X1}/E_{X2}$ are orthogonal to $S_{X1}/S_{X2}$). Thus, the magnetic field $E_{X1}/E_{X2}$ of the excitation coil does not induce a voltage in the stripline 1, i.e. the secondary coil 26 (excitation coil) and the stripline 1. Since the sample accommodating spaces 20 and 22 are arranged substantially symmetrical with respect to the strip, the magnitude of the magnetic fields will be also substantially equal, i.e. $E_{X1} = E_{X2}$.

The magnetic fields of the stripline 1 and the secondary coil 26 may be advantageously utilized for the acquisition of signals from two NMR samples S1 and S2 accommodated in the sample spaces 20 and 22, respectively. As explained above, depending on how the excitation and detection of the signals from the samples S1 and S2 are carried out, it is possible to realize a common mode, a differential mode and/or a mixed measurement mode with the same arrangement. In the common mode the detected signal is proportional to the sum of the signals from the two samples. In the differential mode, the detected signal is proportional to the difference between the signal from the two samples.

In particular, the samples S1 and S2 accommodated in the sample volumes 20 and 22, respectively, can be excited with the RF magnetic field of the stripline, $S_{X1}/S_{X2}$, as shown in Fig. 2, or with the magnetic field from the secondary coil $E_{X1}/E_{X2}$, as shown in Fig. 3, or with any combination of the two. As explained above, the principle of reciprocity states that the resulting signal from an induction in a coil is proportional to the dot product of the field ($B$) created by the coil receiving the signal (receiving or detection coil) and the magnetization ($M$) of a spin (precessing magnetization). Thus, the resulting signal from the reception coil (the stripline 1) corresponds to the signal contributions from the samples S1 and S2 can be approximated as being proportional to:

$$M_{S1} \cdot B_1 + M_{S2} \cdot B_2, \qquad\qquad \text{(see equation 1)}$$

Wherein $M_{S1}$ is the precessing magnetization of the first sample S1, $M_{S2}$ is the precessing magnetization of the second sample S2, $B_1$ is the reception coil magnetic field in the first sample S1 and $B_2$ is the reception coil magnetic field in the second sample S2.

Given that each magnetization $M_{S1}, M_{S2}$ is proportional, after a pulse, to the excitation field ($T_X$) and $B$ represents the excitation field of the reception coil ($R_X$), the detected signal for the two samples S1 with frequency amplitudes $c_{S1}$ and $c_{S2}$, respectively, can be rewritten as:

$$c_{S1} \cdot R_{X1} \cdot T_{X1} + c_{S2} \cdot R_{X2} \cdot T_{X2} \qquad\qquad \text{(see equation 2)}$$

For a readout (i.e. detection) with the same coil as the one used for excitation (for example the stripline 1), the excitation ($T_X$) and reception ($R_X$) fields are the same, i.e. $S_X$, and the detected signal is thus:

$$(c_{S1} + c_{S2}) \cdot S_X \cdot S_X \qquad\qquad \text{(see equation 3)}$$

Thus, a common mode reception of the signals from the two samples S1 and S2 may be realized.

If the excitation is carried out with the secondary coil ($T_X$), i.e. secondary coil 26, and the reception with the stripline ($S_X$), and considering that $E_{X1} \cdot S_{'X1} = -E_{X2} \cdot S_{'X2}$, one obtains a detected signal of:

$$(c_{S1} - c_{S2}) \cdot S_X \cdot E_X \qquad \text{(see equation 4)}$$

Thus, a differential mode reception of the signals from the two samples S1 and S2 may be realized.

If the excitation is carried out with both the secondary coil ($T_X$), i.e. secondary coil 26, and the reception (i.e. detection) with the stripline 1, a mixed type measurement mode may be realized, as explained above.

As explained above, the principle of operation of the NMR detector may be generalized to any pair of structures configured such as to fulfill equation (5) or (5'), namely:

$$\iiint_{Space\ 1} R_{X1} \cdot M(T_{X1}) = -\iiint_{Space\ 2} R_{X2} \cdot M(T_{X2}) \qquad \text{(see equation 5)}$$

$$R_{X1} \cdot T_{X1} = -R_{X2} \cdot T_{X2}, \qquad \text{(see equation 5')}$$

wherein:

$T_{X1}$ and $T_{X2}$ are the magnetic fields across the first sample S1 and the second sample S2, respectively (i.e. the magnetic fields in the first and the second sample volume, respectively); and

$R_{X1}$ and $R_{X2}$ are the reception magnetic fields across the first sample S1 and the second sample S2, respectively (i.e. the magnetic fields in the first and the second sample volume, respectively);

$M(T_{Xi})$, $i$ = 1, 2 is the magnetization as a function of the magnetic field generated by the excitation coil;

Space 1 is the first sample accommodating space; and

Space 2 is the second sample accommodating space.

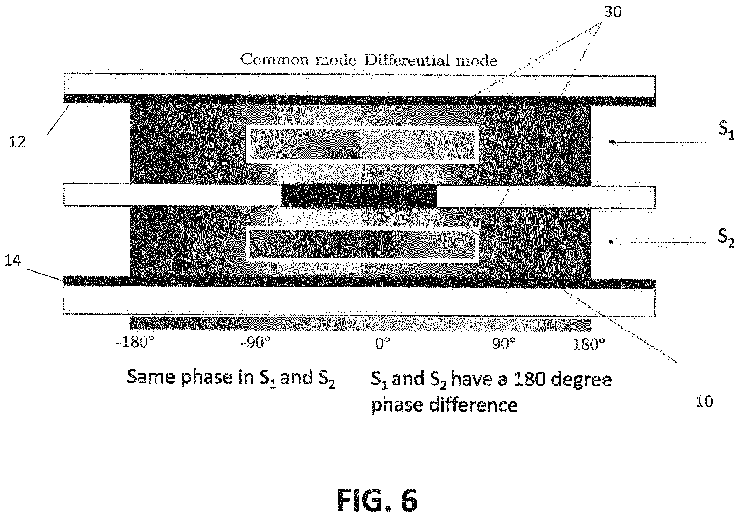

**Figure 6** shows the phase of MRI images of two samples S1 and S2 above and below the strip in an exemplary stripline NMR detector for a common mode measurement (left) and a differential mode measurement (right). A pixel grayscale value inside the white boxes 30 refers to pixel phase, and outside the white boxes 30 to pixel intensity. In the common mode measurement shown to the left, a single coil is employed for both excitation and detection. In the differential mode measurement shown to the right, two separate coils are employed for excitation and detection, respectively. Fig. 6 reveals the phase between different spins in different parts of the samples. For a common mode measurement, the phase is approximately equal for the two samples S1 and S2. For a differential mode measurement, there is approximately 180° phase difference between both samples, below and above the strip.

Much like for coaxial cables, striplines have little interaction with the volume outside of the shielding. Thus, by reciprocity, the signal is shielded from outside interference before amplification. The stripline coil can, therefore, be made resonant using for example at least one capacitor 24 placed inside the shield (i.e. between the top and bottom shielding plates 12 and 14), so as not to disturb this effect.

**Experimental results**

In an example, the performance of a stripline NMR detector having the structure shown in Figs. 1 to 5 was experimentally confirmed. The stripline NMR detector comprised a central PCB containing the strip and two additional PCBs having Cu layers that realise the shielding/return paths. The two additional PCBs were 1mm-thick PCB (Multi Circuit Boards) with 70 $\mu$m thick top and bottom Cu layers spanning 34 mm x 43 mm. The inter-PCB connections were realized using several pins (e.g. TMM/CLT, SAMTEC) connected in parallel to lower their contact resistance. The total stack thickness was 11.1 mm, allowing for two sample gaps or spaces of 4 mm and 3.8 mm.

The effective shielding was measured in a configuration where the top PCB (including the top shielding plate 12) was removed, thereby converting the arrangement to a microstrip configuration. The measurement was performed by comparing the coupling the transceiver to a sniffer coil that was symmetrically placed once below (shielded) and then above (unshielded) center PCB. The effective shielding was measured to be approximately 27 dB.

A second critical effect that typically disadvantages the use of most detectors in a gap magnet is the generation of eddy currents in nearby metallic surfaces. These would in turn counter the generated $B_1$ field, and thus significantly reduce the detector's sensitivity. The stripline design is immune to this effect as only a negligible magnetic field amplitude is created outside of the shielding surface.

This has been confirmed experimentally. Due to the very low inductance and resistance of the stripline, its lumped parameter values were acquired indirectly by measuring it in a resonant circuit, using an impedance analyzer (E4991A, Agilent Technologies), whose results were fitted to an LC lumped-model (Advanced Design System, Keysight). Several capacitors were used in parallel (non-magnetic 1111E Series, Johanson Technology), allowing for high quality factors (Q), which, along with the varactors (BB659, Infineon), created a net capacitive system with 1.68 nF and 2.1 m$\Omega$ ($Q_C$ > 1000). From this, a resonator with L=7.7 nH and $R_L$=14m$\Omega$ ($Q_L$ =154) was obtained, which corresponded to a real impedance, at resonance, of R = 335 $\Omega$. Due to the finite resistance of the capacitor/varactor system, these values were found to be degraded to an effective resonator quality factor of $Q_{LC}$ = 133 and a resistance of 290 $\Omega$.

The end goal of an NMR detector is to achieve a high sensitivity to the contained precessing magnetization **M**. A number of measures were taken alone or in combination to insure a reliable measurement of the end figure-of-merit of the detector. To measure the sensitivity of the NMR detector, a small capillary (ID=0.8 mm, L=8 mm) was used as a sample to remove any possible influence from radiation damping, field and excitation inhomogeneity, and drifts during measurement. A nutation spectrum was measured to maximize the tilt angle on the sample inside the capillary, using only the stripline as a transceiving coil and no other components (switch, varactors, etc.). This signal corresponded to that of a total $^1H$ magnetization from distilled water of 3.5 mAm$^{-1}$, as calculated following a procedure reported by Hoult et al. (D. Hoult and R. Richards, Journal of Magnetic Resonance, (1969), 1976, 24, 71-85), as measured with the sample placed along the length of the stripline in a volume with 0.8 relative sensitivity. The FID was recorded, and had its beginning fitted to the observed exponential decay, allowing the voltage to be correctly extrapolated to $t \rightarrow 0$ $s$, by removing the effect of the 1 ms dead-time and thus any voltage contribution from ringing. The maximum $Q$-amplified stripline voltage was thus 27.8 $\mu$V.

The isolated, non-tuned LC tank was characterized ($G_Q \approx 9$ << 133), the external LNA's gain was removed ($G_{ICON}$ = 29.3 dB), and the voltage was input-referred to the unamplified stripline's voltage, obtaining 266 nV and consequently a maximum sensitivity of 5.7 x 10$^{-4}$ TA$^{-1}\Omega^{-0.5}$. This represents a universal figure of merit for the detector which can be adapted to compute other more intuitive metrics for performance, such as the limit of detection (LOD). LOD requires assumptions on the $B_0$, pulse sequence and measurement time used, which means its extrapolation power is fairly limited. However, adapting the reasoning in Badilita *et al.* (V. Badilita, R. C. Meier, N. Spengler, U. Wallrabe, M. Utz and J. G. Korvink, Soft Matter, 2012, 8, 10583-10597) one can infer the minimum volume of water that could be measured in a single experiment at the $B_0$ field used as $968pL/\sqrt{Hz}$.

**Reception channel**

To be able to transfer and later digitize the NMR signal with an analogue-to-digital converter (ADC) without sacrificing SNR, the detected NMR signal should preferably be amplified to a sufficient power.

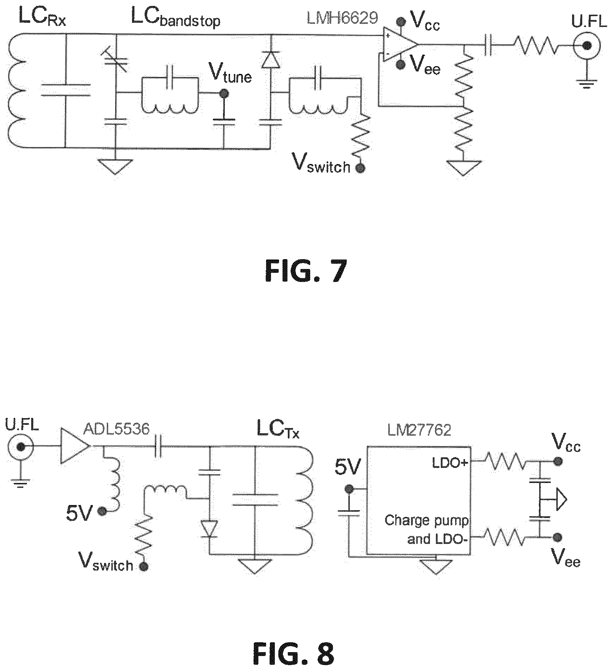

One signal-reception circuit having sufficient performance is based on a high impedance acquisition of the signal across a tuned stripline. Using this technique, one does not need to match the coil's impedance, electrically tuning the resonator for example with a varactor instead. This is a monotonically convergent procedure, that can be automated using a software-controlled voltage, and that works for all frequencies relevant for permanent-magnet systems. **Figure 7** shows an exemplary circuit that may be used for tuning and switching of the reception (detection) coil.

The accessible tuning range depends generally on the ratio of variable to fixed capacitance. It is possible to design the circuit to allow for 1 MHz changes due to the interest in $^1H$ spectra within the $B_0$ range of temperature-drifting NdFeB magnets. Due to the high quality factor of the varactors, only a small degradation of the total $Q$ is observed, as discussed before. An LC notch filter may be placed in the path of the biasing voltage, V$_{tune}$, and the switch lines, V$_{switch}$, to avoid in-band signal/noise leakages, and to filter out-of-band noise. The filter's $Q$ factor may be chosen to match the 1 MHz range of interest.

At resonance, an inductor in parallel with a capacitor sustains an impedance transformation and achieves an amplified real impedance of $R_L(Q^2 + 1) \approx R_LQ^3$).

This impedance change goes along with a $Q$-fold amplification of the signal, conserving SNR, in this case of 133. The resistance value can differ considerably depending on the size, geometry and quality of the NMR coil. An additional active amplification was possible due to the measured OPAMP gain of 24.6 dB, for a total of 68 dB. When compared to a standard 50$\Omega$ matching, this coil has a further amplification of 15 dB to 290 W.

Having a large $Q$ amplification may be advantageous, as can be derived from an adaptation of Friis' formula for the noise factor (NF) in terms of voltage density/gain:

$$F = 1 + \left(\frac{N_{LNA}}{N_{NMR}\cdot Q_{LC}}\right)^2 + \left(\frac{N_{rest}}{N_{NMR}\cdot Q_{LC}\cdot G_{LNA}}\right)^2 \qquad (7)$$

Much as the $Q$ amplification in the denominator reduces the impact of the LNA noise, the pre-amplification is able to render the SNR immune to degradation from further signal processing steps, thereby making the NMR acquisition a straightforward process, with complete acquisition and digitization possible using an SDR board.

Based on the simulation results of the noise factor F using equation (7), a comparison to standard approaches of using 50Ω RF LNAs can be made. These typically have noise factors down to 1.12 (NF=0.5 dB), start at frequencies in the tens of MHz, and require a 2D adjustment of a matching network, whereas the exemplary stripline NMR detector is seen to span all frequencies of interest, from zero-field to strong permanent magnet systems, and is useful with any coil that can be tuned to 50Ω (F=1.97) or above, improving its performance to F=1.32 at 290Ω.

The thermal noise's voltage spectral density expected for the tuned coil, after $Q$ amplification, was 2.17 nVHz$^{-0.5}$ due to the 290Ω resistance. The measured value at the output was of 43.8 nVHz$^{-0.5}$ which, after computing the input-referred value, gives a total noise factor of 1.28 without any external shielding used, which matches the simulated value. This result was possible due for example to the built-in 27 dB shielding on the stripline, and the precautions taken to keep out in-band noise, allowing for an ideal performance front-end without an otherwise common heavy and bothersome shielding layer. For experimental confirmation, a copper/ Metglas shielding box was used to re-characterize the noise, and no further reduction was found.

## Operation and control

An important factor in an NMR detector is that of power transmission for spin excitation. This can be achieved with a monolithic transceiving coil. In the exemplary NMR detector, a secondary and decoupled transmission coil (excitation coil, such as the secondary coil 26) may be employed. There are several benefits in using such coil beyond the homogeneity/sensitivity trade-off. These include the ease of simultaneous transmission and detection techniques, critical in samples with low $T_2$ values, the zero dead-time/ringing involved, as the Tx and Rx coils (i.e. the excitation and the reception coils) need not be simultaneously tuned, and the ability to achieve a broadband matching of the Tx coil (i.e. the excitation coil). The latter is possible due to its low Q, which generally would entail a low sensitivity if also used as a detector. The approach using a secondary and decoupled excitation coil may be particularly important as frequency drifts will be typically measured during the $T_1$ relaxation time of the main $^1H$ sample, by electrically retuning the Rx coil (i.e. the reception coil) and probing an FC43 sample on the $^{19}F$ frequency. This allows for an ideal drift compensation using only one measurement channel, while losing no detection time.

**Figure** 8 shows an exemplary circuit for switching and matching the excitation coil (Tx coil) and for power amplification. The DC chip includes a positive low-dropout (LDO) regulator, a charge pump, and a negative LDO, which create the regulated voltages to feed the OPAMP.

The Tx coil may be connected to the Tx channel with an amplifier, for example an amplifier with a datasheet-stated gain of 20.1 dB and $P_{1dB}$ of 91mW. A 50Ω output may lead to the matching network of the Tx coil, which is acceptably matched in the relevant bandwidth. Further, a switch may be designed so that the coil would only be correctly tuned when the pin diode was conducting, otherwise the coil was tuned to a shifted frequency.

By using the above arrangement, it is possible to tune the coil by maximizing the transmission between the two accessible RF ports, Rx and Tx. Further, high geometrical decoupling between Tx and Rx can be obtained, for example of 73 dB. This remarkable result can be understood when considering that all field lines created by the stripline close inside its shield, meaning they create no flux across the solenoid, and thus induce no voltage.

Another useful characteristic, despite the high level of decoupling, is the ability to easily switch between Tx and Rx modes. This may be done with a TTL-controlled line which biases two pin diodes, through an LC notch filter at the NMR frequency, so as to block incoming noise/outgoing power while allowing for fast switching of the DC level of the line. At 0V (Rx mode), the diode on the Rx coil does not affect measurement, and the excitation coil is tuned to a high frequency. At 5V (Tx mode), the stripline is shorted, whereas the excitation coil has an increased capacitance to ground, thus adjusting its tuning to the NMR frequency.

As explained above, the NMR detector according to some of the above aspects and examples employs a separate, independent excitation (Tx coil or secondary coil) that is geometrically decoupled from the reception coil (Rx coil). In an example, the magnetic field generated by the secondary excitation coil is orthogonal to the magnetic field of the stripline. For example, the Tx coil may be constituted by an array of parallel straight tracks, perpendicular to the axis of the stripline, all connected electrically in parallel and placed on the outermost layers of a PCB assembly. Considering that an infinite current sheet creates a uniform magnetic field across all directions, this constitutes a very good approximation of a design that combines both decoupling, great directional precision of the magnetic field and homogeneity. The connection of both track planes resembles then a long, flattened solenoid, but without the chirality of solenoidal windings. For complex pulse sequences, Tx uniformity is of paramount importance, and thus also the homogeneity of the magnetic field generated by the excitation coil.

In an example, a commercially available open-source SDR board, the LimeSDR (Lime Microsystems, UK) may be employed as a back-end to be connected to a resonator described in detail above. The board offers two channels with transmission/reception (Tx/Rx) radiofrequency (RF) control, so that a complete spectrometer solution can be realized.

Further, in some examples, the NMR detector may be provided with suitable interface electronics to correct for power and noise limitations introduced by the spectrometer, so as not to compromise the measurement's operational tunability and signal-to-noise ratio.

The NMR detector according to aspects and examples described above, showcases the first implementation of a stripline in low-field NMR. The detector may be optimized for detection sensitivity on narrow flat sample spaces, performing near the theoretically best noise figure without additional shielding, and with adequate operational times for liquid-state NMR. This effectively enables NMR as a standalone, planar device to be used in milliscale applications, including most micro Total Analysis Systems ($\mu$TAS). The active volume of the NMR detector may be easily downscaled, for example reduced to the millimeter range, whilst retaining its NMR performance. Further, the NMR detector according to aspects and examples described above, can be easily configured to measure a spectrum on sub-nL volumes, making it well-suited for microfluidic samples.

The NMR detector can be easily integrated in an NMR integrated system, including magnetic layers. It can also be easily integrated with PCB shims, which may be needed to correct for the large magnetic field inhomogeneity inherent to permanent magnet designs. Further, the thermal drifts in magnetization, usually a major concern, might have less impact, as the described approach allows for electrical retuning, broadband excitation, and continuous drift observation on a secondary sample.

Further, it is possible to realize for the first time a geometrically-based differential-mode measurement in NMR as illustrated in Fig. 6. The differential phase shift technique can be readily adapted to any NMR or MRI application, allowing for multi-faceted simplifications in measurements involving any choice of two samples.

A direct application of this technique is the simultaneous comparison of two samples, under the same experimental conditions, resulting in two spectra that have an opposite phase and that are thus easy to tell apart. If two peaks overlap, this creates a total cancellation of the signal, which is particularly useful when wishing to suppress high-abundance peaks (e.g. solvents), without artefacts or the suppression of overlapping information, and when handling complex spectra. It should be clear that any combination of common and differential-mode excitation can be made, meaning that the excitation angle, and thus the signal intensity, can be independently set for each sample, and one can therefore precisely subtract peaks that are up to one million times more abundant than the substance of interest.

Beyond the simplification of the received information, a differential result also directly improves SNR by removing common-mode background signals (e.g. interference/coupling) and shared white-noise sources; reducing the dynamic range of the signal and thus the quantization noise introduced during digitization; and/or narrowing linewidths through drift-corrected averaging and the reduction of radiation damping from large-signals.

The principles described above can be directly extended to magnetic resonance imaging (MRI) if one encompasses both samples in the same excited slice and locally modifies only one of the two samples.

For simplicity and illustrative purposes, the principles of the claimed subject matter are described mainly by referring to examples thereof. Further, numerous specific details are set forth in order to provide a thorough understanding of the examples. It will be apparent however, to one of ordinary skill in the art, that the examples may be practiced without limitation to these specific details. In some instances, well known methods and structures have not been described in detail so as not to unnecessarily obscure the examples. The examples may be used or performed together in different combinations.

Moreover, a number of steps are described. The order of these steps may be modified, even when this is not explicitly stated.

The computational aspects described can be implemented in digital electronic circuitry, or in computer hardware, firmware, software, or in combinations of them. When appropriate, aspects of these systems and techniques can be implemented in a computer program product, for example tangibly embodied in a machine-readable storage device for execution by a programmable processor; and method steps can be performed by a programmable processor executing a program of instructions to perform functions by operating on input data and generating an output.

**List of Reference Numerals**

1 stripline (exemplary reception coil)
10 conductive strip
12 shielding plate

14 shielding plate
16 intermediate layer
18 pins
20 sample accommodating space
22 sample accommodating space
24 capacitor
26 secondary coil (exemplary excitation coil)
30 (image) areas in which pixel grayscale values refer to pixel phases
S1, $S_1$ sample
S2, $S_2$ sample
$Sx_1$ magnetic field generated by the stripline in the area above the stripline
$Sx_2$ magnetic field generated by the stripline in the area below above the stripline
$Ex_1$ magnetic field generated by the secondary coil in the area above the stripline
$Ex_2$ magnetic field generated by the secondary coil in the area below the stripline

## Claims

1. An NMR detector comprising:

   a first sample accommodating space (20);
   a second sample accommodating space (22),
   at least one excitation coil (26) configured to generate a unidirectional magnetic field across the first and the second sample accommodating spaces; and
   at least one reception coil (1) configured to:

   generate a magnetic field across the first and the second sample accommodating spaces (20, 22), wherein the magnetic field vectors of the generated magnetic field have opposite directions in the first and the second sample accommodating spaces (20, 22), respectively; and
   simultaneously receive a first NMR signal from a first sample (S1) accommodated in the first sample accommodating space (20) and a second NMR signal from a second sample (S2) accommodated in the second sample accommodating space (22), thereby generating a compound NMR signal.

2. The detector according to claim 1, wherein the excitation coil (26) and the reception coil (1) are configured such that the following condition is fulfilled:

$$\iiint_{Space\ 1} R_{X1} \cdot M(T_{X1}) = - \iiint_{Space\ 2} R_{X2} \cdot M(T_{X2})$$

wherein:

   $T_{X1}$ is the magnetic field generated by the excitation coil (26) across the first sample accommodating space (20);
   $T_{X2}$ is the magnetic field generated by the excitation coil (26) across the second sample accommodating space (22);
   $R_{X1}$ is the magnetic field generated by the reception coil (1) across the first sample accommodating space (S1); and
   $R_{X2}$ is the magnetic field generated by the reception coil (1) across the second sample accommodating space (S2);
   $M(T_{Xi})$, $i$ = 1, 2 is the magnetization as a function of the magnetic field generated by the excitation coil (26);
   Space 1 is the first sample accommodating space (20); and
   Space 2 is the second sample accommodating space (22).

3. The detector according to claim 1 or 2, wherein
   the NMR detector is configured to perform excitation of the first sample (S1) and the second sample (S2) by the magnetic field generated by the excitation coil (26), wherein the compound NMR signal generated by the reception coil (1) is proportional to the difference between the first NMR signal and the second NMR signal; or

the NMR detector is configured to perform excitation of the first sample (S1) and the second sample (S2) by the magnetic field generated by the reception coil (1), wherein the compound NMR signal generated by the reception coil (1) is proportional to the sum of the first NMR signal and the second NMR signal; or

the NMR detector is configured to perform excitation of the first sample (S1) and the second sample (S2) by the magnetic field generated by the excitation coil (26) and the magnetic field generated by the reception coil (1).

4. The detector according to any one of the preceding claims, wherein the magnetic field generated by the excitation coil is substantially orthogonal to the magnetic field generated by the reception coil.

5. The detector according to any one of the preceding claims, wherein the reception coil (1) is a stripline comprising a strip (10) of conductive material arranged between two substantially parallel shielding plates (12, 14).

6. The detector according to claim 5, further comprising at least one capacitor (24) and/or at least one varactor arranged partially or fully in the space between the shielding plates (12, 14) of the stripline (1).

7. The detector according to any one of the preceding claims, further comprising at least one sample holder comprising at least one substantially planar channel having a height-to-width aspect ratio in the range of 0.1 to 10.

8. An NMR system comprising

a magnet having a first and a second substantially planar magnetic layers; and

an NMR detector according to any one of the preceding claims, said NMR detector being arranged between the first and the second magnetic layers.

9. A method for performing an NMR measurement of a first sample (S1) and a second sample (S2), comprising

providing at least one excitation coil (26) configured to generate a unidirectional magnetic field across the first sample (S1) and the second sample (S2);

providing at least one reception coil (1) configured to generate a magnetic field across the first sample (S1) and the second sample (S2), respectively, wherein the magnetic field vectors of the generated magnetic field have opposite directions in the first and the second samples (S1, S2), respectively; and

exciting the first sample (S1) and the second sample (S2) by the magnetic field generated by the at least one excitation coil (26) and/or the magnetic field generated by the at least one reception coil (1); and

detecting, by the at least one reception coil (26) a compound NMR signal by simultaneously receiving a first NMR signal from the first sample (S1) and a second NMR signal from the second sample (S2), said first and second samples (S1, S2) being subjected to said magnetic field generated by the reception coil (26).

10. The method according to claim 9, wherein the generated magnetic fields fulfill the condition:

$$\iiint_{Space\ 1} R_{X1} \cdot M(T_{X1}) = - \iiint_{Space\ 2} R_{X2} \cdot M(T_{X2})$$

wherein:

$T_{X1}$ is the magnetic field generated by the excitation coil (26) across the first sample accommodating space (20);

$T_{X2}$ is the magnetic field generated by the excitation coil (26) across the second sample accommodating space (22);

$R_{X1}$ is the magnetic field generated by the reception coil (1) across the first sample accommodating space (20); and

$R_{X2}$ is the magnetic field generated by the reception coil (1) across the second sample accommodating space (22);

$M(T_{Xi})$, $i$ = 1, 2 is the magnetization as a function of the magnetic field generated by the excitation coil;

Space 1 is the first sample accommodating space; and

Space 2 is the second sample accommodating space.

11. The method according to claim 9 or 10, wherein:

the first sample (S1) and the second sample (S2) are excited by the magnetic field generated by the excitation coil (26) and the detected NMR compound signal is proportional to the difference between the first NMR signal and the second NMR signal; or

the first sample (S1) and the second sample (S2) are excited by the magnetic field generated by the reception coil (1) and the detected NMR compound signal is proportional to the sum of the first NMR signal and the second NMR signal; or

the first sample (S1) and the second sample (S2) are excited by the magnetic field generated by the excitation coil (26) and the magnetic field generated by the reception coil (1).

12. The method according to any one of claims 9 to 11, wherein the reception coil (1) is a stripline comprising a strip (10) of conductive material arranged between two substantially parallel shielding plates (12, 14).

13. The method according to claim 12, further comprising adjusting the resonant frequency of the reception coil (1) by at least one capacitor (24) and/or at least one varactor arranged partially or fully in the space between the shielding plates (12, 14) of the stripline (1).

14. The method according to any one of claims 9 to 13, further comprising providing an NMR detector according to any one of claims 1 to 7, said NMR detector comprising said excitation coil (26) and reception coil (1).

15. The use of an NMR detector according to any one of claims 1 to 7 for performing NMR measurement of a fluid sample or for obtaining MRI images of a sample.

**FIG. 1**

**FIG. 2**

**FIG. 3**

EP 3 719 521 A1

EP 3 719 521 A1

**Stripline**
(1)

S₁ Ex₁ Sx₁ 20

S₂ Sx₂ Ex₂

13
12
14
15
10
22

# FIG. 4

**Solenoid**
(26)

S₁ Sx₁ Ex₁ 20

S₂ Sx₂ Ex₂ 22

13
10
15

# FIG. 5

**FIG. 6**

LC$_{Rx}$   LC$_{bandstop}$   LMH6629   V$_{cc}$   U.FL

V$_{tune}$

V$_{ee}$

V$_{switch}$

**FIG. 7**

U.FL   ADL5536   LC$_{Tx}$   LM27762   V$_{cc}$

5V   LDO+

5V

Charge pump
and LDO-

V$_{switch}$   V$_{ee}$

**FIG. 8**

Europäisches
Patentamt

European
Patent Office

Office européen
des brevets

## EUROPEAN SEARCH REPORT

Application Number

EP 19 16 7579

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2002/130661 A1 (RAFTERY DANIEL [US] ET AL) 19 September 2002 (2002-09-19) | 1-4, 8-11,14, 15 | INV. G01R33/345 G01R33/36 |
| Y | * paragraph [0106] - paragraph [0111] * * figure 31 * | 5-7,12, 13 | G01R33/46 G01R33/56 |
| Y | US 2018/210042 A1 (MOHEBBI HAMIDREZA [CA] ET AL) 26 July 2018 (2018-07-26) * paragraph [0013] - paragraph [0034] * | 5,6,12, 13 | ADD. G01R33/30 G01R33/34 |
| Y | US 2018/292476 A1 (BUTLER MARK C [US] ET AL) 11 October 2018 (2018-10-11) * paragraph [0022] * | 7 | |
| A | US 2017/030985 A1 (GERALD II REX E [US]) 2 February 2017 (2017-02-02) * paragraph [0040] - paragraph [0046] * | 1-15 | |

TECHNICAL FIELDS
SEARCHED (IPC)

G01R

The present search report has been drawn up for all claims

| Place of search | Date of completion of the search | Examiner |
|---|---|---|
| Munich | 2 October 2019 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 19 16 7579

This annex lists the patent family members relating to the patent documents cited in the above-mentioned European search report.
The members are as contained in the European Patent Office EDP file on
The European Patent Office is in no way liable for these particulars which are merely given for the purpose of information.

02-10-2019

| Patent document cited in search report | | Publication date | Patent family member(s) | | | Publication date |
|---|---|---|---|---|---|---|
| US 2002130661 | A1 | 19-09-2002 | AU | 3007300 | A | 14-09-2000 |
| | | | US | 2002130661 | A1 | 19-09-2002 |
| | | | US | 2004164738 | A1 | 26-08-2004 |
| | | | WO | 0050924 | A1 | 31-08-2000 |
| US 2018210042 | A1 | 26-07-2018 | CA | 2990276 | A1 | 26-01-2017 |
| | | | EP | 3325991 | A1 | 30-05-2018 |
| | | | US | 2018210042 | A1 | 26-07-2018 |
| | | | WO | 2017011897 | A1 | 26-01-2017 |
| US 2018292476 | A1 | 11-10-2018 | US | 2018292476 | A1 | 11-10-2018 |
| | | | WO | 2018190941 | A2 | 18-10-2018 |
| US 2017030985 | A1 | 02-02-2017 | NONE | | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **E. GHAFAR-ZADEH ; H. POURMODHEJI ; S. MAGIEROWSKI.** Differential nuclear magnetic resonance receiver: Design, implementation and experimental results. *IEEE International Symposium on Circuits and Systems (ISCAS),* 2016, 105-108
- **D. HOULT ; R. RICHARDS.** The signal-to-noise ratio of the nuclear magnetic resonance experiment. *Journal of Magnetic Resonance,* 1969, vol. 24, 71-85
- **D. HOULT ; R. RICHARDS.** *Journal of Magnetic Resonance,* 1969, vol. 24, 71-85
- **HOULT ; D. HOULT ; R. RICHARDS et al.** *Journal of Magnetic Resonance,* 1969, vol. 24, 71-85
- **V. BADILITA ; R. C. MEIER ; N. SPENGLER ; U. WALLRABE ; M. UTZ ; J. G. KORVINK.** *Soft Matter,* 2012, vol. 8, 10583-10597